Europäisches Patentamt

European Patent Office

Office européen des brevets

(19)

(11) Veröffentlichungsnummer: **0 010 214**
**B1**

(12) **EUROPÄISCHE PATENTSCHRIFT**

(45) Veröffentlichungstag der Patentschrift:
**14.04.82**

(21) Anmeldenummer: **79103736.9**

(22) Anmeldetag: **01.10.79**

(51) Int. Cl.³: **A 63 H 19/24**, **H 01 F 29/06**,
**H 01 H 19/10**, **H 01 H 85/08**,
**H 05 K 1/00**

(54) **Stelleinrichtung für Netzanschlussgeräte, insbesondere für elektrische Spielzeug- und Modelleisenbahnen.**

(30) Priorität: **14.10.78 DE 7830650 U**

(43) Veröffentlichungstag der Anmeldung:
**30.04.80 Patentblatt 80/9**

(45) Bekanntmachung des Hinweises auf die Patenterteilung:
**14.04.82 Patentblatt 82/15**

(84) Benannte Vertragsstaaten:
**AT CH DE FR GB IT NL SE**

(56) Entgegenhaltungen:

AT-B-324 470
DE-A1-2 703 255
DE-A1-2 734 994
DE-A1-2 813 774
DE-U-7 503 470
GB-A-1 476 885

SIEMENS-ZEITSCHRIFT, Band 50, Heft 11, 1976
H. HADERSBECK et al. «Grossformatige, flexible gedruckte Verdrahtungen in Geräten der Nachrichtentechnik» Seiten 723 bis 726

(73) Patentinhaber: **SIEMENS AKTIENGESELLSCHAFT Berlin und München, Postfach 22 02 61, D-8000 München 22 (DE)**

(72) Erfinder: **Bradt, Peter, Bachstrasse 10, D-2875 Ganderkesee (DE)**

ACTORUM AG.

## Stelleinrichtung für Netzanschlussgeräte, insbesondere für elektrische Spielzeug- und Modelleisenbahnen

Die Erfindung bezieht sich auf eine Stelleinrichtung für Netzanschlussgeräte, insbesondere für elektrische Spielzeug- und Modelleisenbahnen, der im Oberbegriff des Patentanspruchs 1 angegebenen Art; eine derartige Stelleinrichtung ist durch das DE-U-7 503 470 bekannt.

Bei der bekannten Stelleinrichtung sind die auf der Tragplatte gehaltenen Dioden untereinander durch Verlöten ihrer entsprechenden Anschlussleitungen zu einer Brückengleichrichter-Anordnung zusammengeschaltet. Die elektrische Verbindung der Dioden mit den in der Tragplatte zumindest axial beweglich gehaltenen und bei Drehung der Tragplatte um die Achse auf den Leiterbahnen der ersten starren Schaltungsplatte schleifenden Schleifkontakten bzw. der Schleifkontakte untereinander erfolgt mittels beidseitig jeweils an die Anschlussleitungen der Dioden bzw. Kontakthülsen der Schleifkontakte einzeln anzulötender diskreter Litzen.

Aufgabe der vorliegenden Erfindung ist es, die Fertigung einer Stelleinrichtung mit den darin befestigten und mit den beweglichen Kontakten zu verbindenden elektronischen Bauelementen bei Gewährleistung einer hohen Betriebssicherheit zu vereinfachen.

Die gestellte Aufgabe wird bei einer Stelleinrichtung der eingangs genannten Art erfindungsgemäss durch die kennzeichnenden Merkmale des Patentanspruchs 1 gelöst; dadurch ist es in einfacher Weise in einem Arbeitsgang möglich, sowohl die der Schleiffläche abgewandten Enden der Schleifkontakte und die Dioden an der Schaltungsplatte mechanisch zu befestigen als auch sämtliche Dioden untereinander bzw. die Dioden mit den Schleifkontakten beispielsweise durch ein Schwallbadlöten, über die auf die flexible Schaltungsplatte aufgedruckten Leiterbahnen elektrisch zu verbinden, wobei insbesondere auch eine allen Betriebsbedingungen genügende elektrische Verbindung zwischen den axial geführt beweglichen Schleifkontakten einerseits und den weitgehend fest angeordneten Dioden andererseits ohne die Notwendigkeit einzeln anzulötender diskreter Litzen gewährleistet ist.

Flexible Verdrahtungsfolien sind an sich bekannt; doch wurden diese als mechanisch sehr widerstandsfähig bezeichneten Verdrahtungsfolien bisher für einen Netztransformator mit drehbeweglichen Stellgliedern nicht benutzt und insbesondere zur direkten festen Verlötung und somit mechanischen Befestigung sowie Verschaltung von betriebsmässig senkrecht zur Verdrahtungsfolie beweglichen, steifen Kontaktstiften offenbar für nicht geeignet gehalten.

Insbesondere für den Fall, dass die Dioden der Stelleinrichtung nicht in jeder Einstellung des Netzanschlussgerätes in gleicher fester elektrischer Verbindung zueinander stehen, sondern beispielsweise im Sinne eines einstellbaren Voll-, Halb- und Mischwellenbetriebes untereinander in unterschiedliche Schaltverbindung bringbar sind, ist es vorteilhaft, dass zum Schutz der Stelleinrichtung gegen Überlastung durch einen inneren, nicht über die Ausgangsklemmen der Stelleinrichtung fliessenden Kurzschlussstrom aufgrund eines Defekts einer Diode mit Freigabe eines Strompfads in der Dioden-Sperrichtung die entsprechenden flexiblen Leiterbahnen der flexiblen Schaltungsplatte im Sinne von Schmelzsicherungen mäanderförmig mit definiertem Leiterquerschnitt ausgeführt sind. Eine Stelleinrichtung mit im Sinne eines Voll-, Halb- bzw. Mischwellenbetriebes u.U. mit zusätzlich verschiedener Amplitude umschaltbaren und an die Sekundärwicklung des speisenden Transformators anschliessbaren Dioden ist in der DE-A1-2 813 774 beschrieben.

Durch die erfindungsgemässe vorgesehene vorteilhafte flexible Schaltungsplatte mit im Zuge der Leiterbahnen gleichzeitig aufgedruckten mäanderförmigen Schmelzsicherungen können bei einer derartigen Stelleinrichtung Überlastungsfälle aufgrund eines inneren Kurzschlussstromes durch Durchschmelzen zumindest einer Schmelzsicherung auf einfache Weise verhindert werden, während ein Schaden durch einen äusseren, über die Ausgangsklemmen fliessenden Kurzschlussstrom durch Ansprechen eines an sich bekannten unmittelbar den Ausgangsklemmen vorzuschaltenden Thermoauslösers verhindert wird, der nach Aufhebung des Kurzschlusses und ggf. einer anschliessenden Abkühlungsphase die Stelleinrichtung bzw. den Stelltransformator wieder betriebsbereit freigibt.

Es ist zwar ein als Leiterbahnstück mit verengtem Querschnitt auf einer Verdrahtungsfolie aufgedrucktes elektrisches Sicherungselement bekannt (GB-A-1 476 885), jedoch ergibt das keinen unmittelbaren Hinweis auf das für vorliegenden speziellen Anwendungszweck vorgesehene Dioden-Schutzelement in Form von mäanderförmigen verengten Leiterbahnen, derart dass die mäanderförmige Anordnung einen zusätzlichen, ein Durchschmelzen fördernden Erhitzungseffekt und damit ein sicheres rechtzeitiges Abschalten bei einem inneren Kurzschluss ohne Gefahr eines inneren Brandes des Netztrafos gewährleistet, wozu das äussere Sicherungselement nicht in der Lage wäre.

Die Erfindung sowie weitere vorteilhafte Ausgestaltungen werden im folgenden anhand eines schematisch dargestellten Ausführungsbeispiels in der Zeichnung näher erläutert. Darin zeigen:

Fig. 1 die Draufsicht auf die um eine Drehachse und über eine starre erste Schaltungsplatte schwenkbare Tragplatte einer bekannten Stelleinrichtung,

Fig. 2 einen Teilquerschnitt gemäss der Schnittlinie II-II in Fig. 1,

Fig. 3 die starre erste Schaltungsplatte einer in der DE-A1-2 813 774 beschriebenen Stelleinrichtung,

Fig. 4 den Querschnitt durch Tragplatte, erste Schaltungsplatte und zweite flexible Schaltungsplatte einer erfindungsgemässen Stelleinrichtung,

Fig. 5 eine Draufsicht auf die flexible Schaltungsplatte einer erfindungsgemässen Stelleinrichtung.

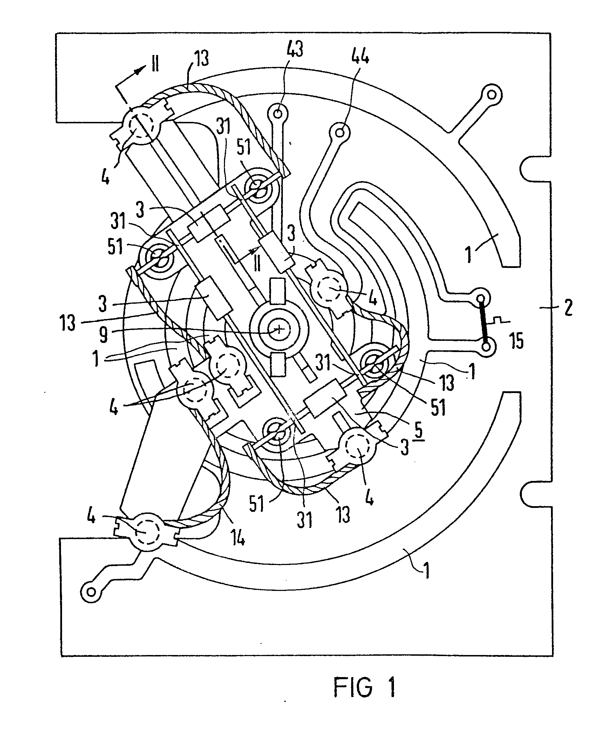

Die bekannte Stelleinrichtung gemäss Fig. 1 bis 3 besteht im wesentlichen aus der mit aufgedruckten Leiterbahnen 1 versehenen ersten starren Schaltungsplatte 2 und der konzentrisch zu dieser um eine Achse 9 schwenkbaren Tragplatte 5 mit daran befestigten Dioden 3 und axial beweglich gehaltenen Schleifkontakten 4. Die Stelleinrichtung ist beispielsweise in hier nicht näher dargestellter Art eingangsseitig an die Sekundärwicklung eines Transformators und ausgangsseitig über die Anschlüsse 43, 44 an einen Gleichstromverbraucherkreis, insbesondere eine Spielzeug- und Modelleisenbahn, anschliessbar. Die einzelnen von den Schleifkontakten 4 bestrichenen Leiterbahnen 1 der Schaltungsplatte 2 haben die Funktion von Polwender-Kontaktbahnen, Überbrückungs-Kontaktbahnen oder Wechselstrom-Kontaktbahnen. Die in Fig. 1 nicht dargestellte Sekundärwicklung des Transformators reicht in Form eines Teilkreises in die linke Öffnung der Schaltungsplatte 2, derart dass sie von den den radial äusseren Kontaktbahnen zugeordneten Schleifkontakten 4 im Sinne eines kontinuierlich veränderbaren Spannungsabgriffs bestrichen werden kann.

Die Tragplatte 5 ist als Kunststoffpressteil mit Führungshülsen 52 zur Aufnahme der durch Druck einer Feder 10 gegen die Leiterbahnen 1 der ersten Schaltungsplatte 2 gedrückten Schleifkontakte 4 und mit angeformten Vorsprüngen 51 zur einknöpfbaren Halterung der Anschlussleitungen der Dioden 3 ausgebildet. An den Kreuzungspunkten 31 der Anschlussleitungen der Dioden 3 sind diese zusammengelötet, derart dass sich eine Dioden-Vollweg-Brückengleichrichter-Anordnung ergibt. Zur Verbindung der Schleifkontakte 4 mit den Dioden 3 sind diskrete Litzen 13 jeweils an ihren Enden einzeln mit einem Schleifkontakt 4 oder einer Anschlussleitung einer Diode 3 verlötet; weitere Litzen 14 dienen zur Verbindung zweier Schleifkontakte 4 untereinander und sind dazu entsprechend an ihren Enden mit den Schleifkontakten einzeln verlötet.

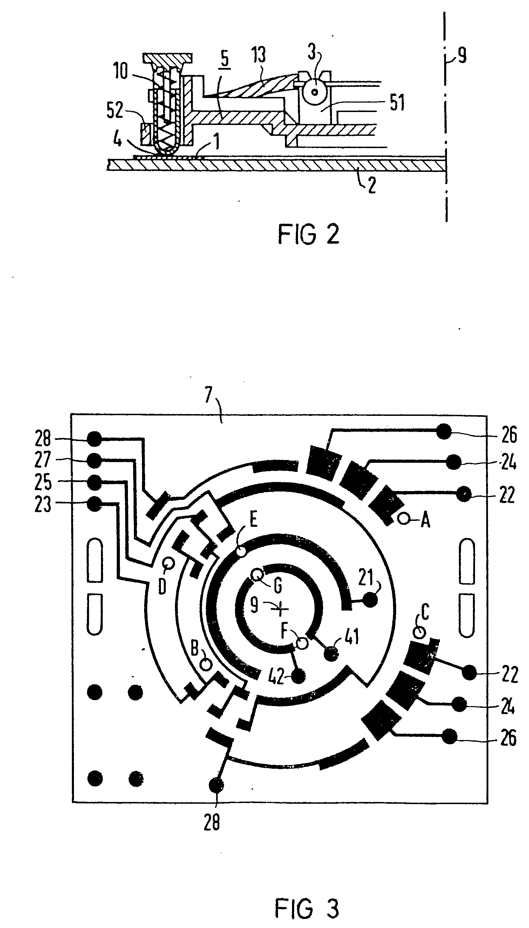

Die Figuren 3 bis 5 zeigen Teile einer Stelleinrichtung eines Stelltransformators für elektrische Spielzeug- und Modelleisenbahnen mit zumindest einer Transformator-Sekundärwicklung und einer über eine Spannungsstelleinrichtung angeschlossenen Brückengleichrichter-Anordnung, deren Ausgangsspannung durch Änderung einer Anschlussverbindung von einem Halbwellen- auf einen Vollwellenbetrieb umstellbar ist, wobei die Enden der im Vollwellenbetrieb an den einen Anzapfpunkt der Sekundärwicklung gemeinsam angeschlossenen Brückenzweige der mit Dioden bestückten Brückengleichrichter-Anordnung zusätzlich je für sich und an zumindest einen weiteren Anzapfpunkt der Sekundärwicklung im Sinne eines Halb-, Voll- oder Mischwellenbetriebes mit einem gegenüber dem Vollwellenbetrieb veränderten Sekundärspannungswert und entsprechend veränderten Gleichspannungswert an den Ausgangsklemmen 41, 42 der Stelleinrichtung anschliessbar sind. Dazu sind sechs Dioden 31 - 34; 36, 37 der Brückengleichrichter-Anordnung gemäss Fig. 3, 5 derart untereinander verbunden und durch Verschwenken der Tragplatte 6 und damit der veränderten Stellung der Schleifkontakte A - G gegenüber den Leiterbahnen der ersten starren Schaltungsplatte 7 zueinander und zu den Anzapfpunkten 21 - 28 der Sekundärwicklung des Transformators in unterschiedlichen Schaltstellungen verbindbar, dass an den Ausgangsklemmen 41, 42 eine Gleichspannung unterschiedlicher Amplitude und/oder unterschiedlicher Halb-, Voll- oder Mischwellenform abgreifbar ist. Verschiedene derartige Spannungsformen am Ausgang der Stelleinrichtung sind in dem Beiblatt «Einstellungen für Stelltransformator (Fig. 3 - 5)» angegeben.

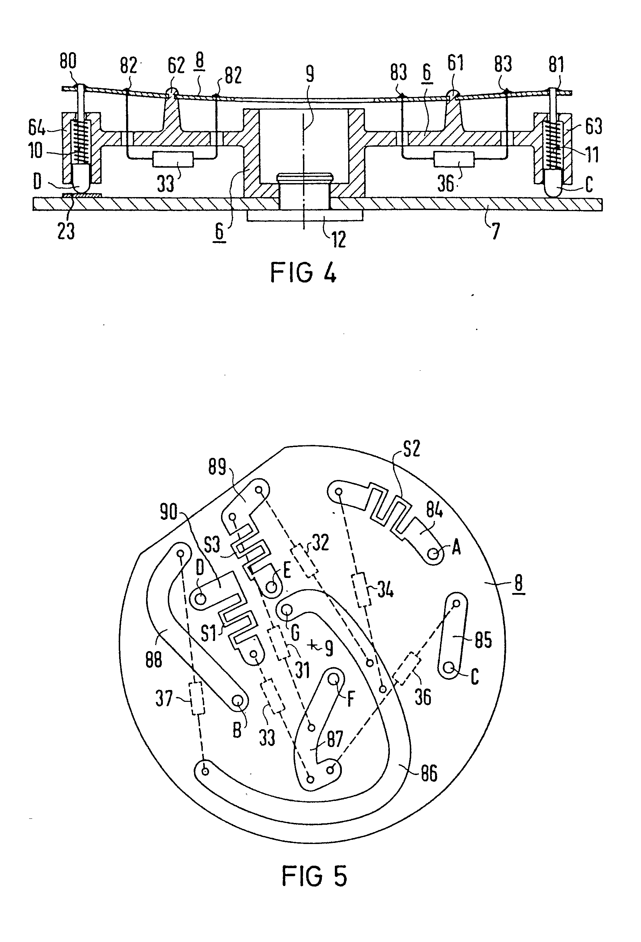

Fig. 4 zeigt eine Tragplatte 6 mit Führungshülsen 63, 64 für die darin axial beweglich gehaltenen und mittels Federn 10, 11 gegen die erste, starre Schaltungsplatte 7 gedrückten hier lediglich dargestellten Schleifkontakte D, C. Auf der ersten, starren Schaltungsplatte 7 sind die in Fig. 3 näher dargestellten Kontaktpunkte bzw. Kontaktbahnen als gedruckte Schaltung aufgetragen. Im dargestellten Schnittbild nach Fig. 4 kontaktiert der Schleifkontakt D mit einem Kontaktpunkt 23, während der Schleifkontakt C gerade ohne Zwischenschaltung einer gedruckten Kontaktstelle direkt auf der ersten Schaltungsplatte 7 aufliegt und daher um ein geringes Mass durch die Feder 11 tiefer nach unten gedrückt ist.

Die Tragplatte 6 ist in ihrem inneren Teil durch einen einknöpfbaren Drehzapfen 12 achskonzentrisch drehbar zu der fest angeordneten ersten, starren Schaltungsplatte 7 gelagert. Oberhalb der Tragplatte 6 ist in Mitnahmeverbindung mit dieser eine zweite, flexible Schaltungsplatte 8 angeordnet. Zur Halterung zwischen der zweiten, flexiblen Schaltungsplatte 8 und der Tragplatte 6 können beispielsweise axial vorstehende Zapfen 61, 62 mit Hinterschneidungen dienen, derart dass die zweite, flexible Schaltungsplatte 8 im Sinne einer Fixierung zur Tragplatte 6 an diesen Zapfen 61, 62 einknöpfbar ist.

Wie insbesondere aus Fig. 5 ersichtlich, trägt die zweite, flexible Schaltungsplatte 8 aufgedruckte Leiterbahnen 84 - 90, die zur Verbindung zwischen den Schleifkontakten A - G und den elektrischen Anschlüssen der Dioden 31 - 34; 36, 37 dienen. Die Schleifkontakte A - G sind in Fig. 3 in einer bestimmten (Nullstellung) Winkelstellung der Tragplatte 6 relativ zur ersten Schaltungsplatte 7 eingetragen, wobei die Anordnung der Leiterbahnen 84 - 90 und der Schleifkontakte A - G auf der flexiblen zweiten Schaltungsplatte 8 der Anordnung der Kontaktpunkte bzw. Kontaktbahnen auf der ersten, starren Schaltungsplatte 7 angepasst ist.

In vorteilhafter Weise sind bei Verwendung der flexiblen zweiten Schaltungsplatte 8 mit den aufgedruckten flexiblen Leiterbahnen 84 - 90 gemäss Fig. 4, 5 in einem Arbeitsgang nicht nur die Verbindungsstellen zwischen den durch Durchbrechungen der Tragplatte 6 durchgeführten Anschlussleitungen der Dioden 31 - 34; 36, 37 sondern auch die Verbindungen der Schleifkontakte A - G, beispielsweise durch ein Schwallbadlöten, hergestellt, wobei die flexible Schaltungsplatte 8 im Bereich der Anlötpunkte 80, 81 der Schleifkontakte in vorteilhafter Weise der axialen Bewegung der Schleifkontakte beim Überschleifen der Kontaktpunkte, Kontaktbahnen oder kontaktfreien Stellen der ersten starren Schaltungsplatte 7 bei Gewährleistung einer sicheren Kontaktierung und freien Beweglichkeit folgen kann.

In vorteilhafter Weise sind bestimmte Leiterbahnen 84, 89, 90 im Sinne von Schmelzsicherungen S1, S2, S3 mäanderförmig mit definiertem Leiterquerschnitt ausgeführt. Durch den Querschnitt dieser Leiterbahnen als auch durch die gegenseitige Zuordnung und Annäherung der Mäanderschleifen kann der Ansprechzeitpunkt, d.h. das Durchbrennen der Schmelzsicherungen u.a. festgelegt werden, so dass beim Ausfall einer Diode und einer Freigabe eines Strompfades in Sperrichtung sowie eines dadurch bedingten inneren Kurzschlussstromes die Stelleinrichtung vor Überlast, insbesondere einer zu starken Erwärmung, rechtzeitig und auf einfache Weise geschützt werden kann.

Einstellungen der Stelleinrichtung (Fig. 3 - 5)

| Kontaktverbindungen | | | Spannungsform | |
|---|---|---|---|---|
| Spannungs-abgriff | Ausgang Gleichrichter | | Ausgang Gleichrichter | |
| Eingang Gleichrichter Ausgang Trafo | Polwendung links | rechts | | |
| A-22 | G-42; F-41 | G-41; F-42 | | Halbwelle |
| B-23 | » | » | | » |
| A-24 | » | » | | » |
| B-25 | » | » | | » |
| A-26 | » | » | | » |
| B-27 | » | » | | » |
| B-27 C-22 | » | » | | Mischwelle |
| B-27 D-23 | » | » | | » |
| B-27 C-24 | » | » | | » |
| B-27 D-25 | » | » | | » |
| B-27 C-26 | » | » | | » |
| B-27 D-27 | » | » | | Vollwelle |
| B-27 C-28 | » | » | | Mischwelle |
| A-28 C-28 | » | » | | Vollwelle |

**Patentansprüche**

1. Stelleinrichtung für Netzanschlussgeräte, insbesondere für elektrische Spielzeug- und Modelleisenbahnen, mit einer um eine Achse (9) drehbaren Tragplatte (6) zur Aufnahme von elektronischen Bauelementen, insbesondere Dioden (31-34, 36, 37), die über angelötete elektrische Leiter mit in der Tragplatte zumindest axial beweglich geführten Schleifkontakten (A - G) verbindbar sind, die gegen gedruckte Leiterbahnen (84-90) auf einer ersten, axial unterhalb der Tragplatte fest angeordneten Schaltungsplatte (7) gedrückt sind, dadurch gekennzeichnet, dass oberhalb der Tragplatte (6) an dieser eine zweite, flexible Schaltungsplatte (8) mit gedruckten Leiterbahnen (84, bis 90) gehaltert und die in der Tragplatte (6) axial beweglich geführten Schleifkontakte (A - G) und die Dioden (31-34; 36, 37) an dieser flexiblen Schaltungsplatte (8) direkt mechanisch befestigt und durch deren gedruckte Leiterbahnen (84-90) elektrisch miteinander verbunden sind (Fig. 4).

2. Stelleinrichtung nach Anspruch 1, dadurch gekennzeichnet, dass zum Schutz der Stelleinrichtung gegen Überlastung durch einen inneren, nicht über die Ausgangsklemmen (41, 42) der Stelleinrichtung fliessenden Kurzschlussstrom aufgrund eines Defekts einer Diode (Strompfad in Sperrichtung) die entsprechenden gedruckten Leiterbahnen (84, 89, 90) der flexiblen Schaltungsplatte (8) im Sinne von Schmelzsicherungen (S1; S2; S3) mäanderförmig mit definiertem Leiterquerschnitt ausgeführt sind (Figur 5).

## Claims

1. An adjusting device for mains connection units, in particular for electrical toy and model trains, comprising a carrier plate (6), which can be rotated about an axis (9), for the accomodation of electronic components, in particular diodes (31-34; 36, 37) which can be connected by means of soldered electrical conductors to sliding contacts (A - G) which are guided in the carrier plate so as to be at least axially movable and which are pressed against printed conductor paths (84-90) on a first circuit board (7) which is fixed axially below the carrier plate, characterised in that a second, flexible circuit board (8) having printed conductor paths (84 to 90) is mounted on the carrier plate (6) above the latter and the sliding contacts (A - G) which are guided in the carrier plate (6) so as to be axially movable and the diodes (31-34; 36, 37) are directly mechanically secured to this flexible circuit board (8) and are electrically connected to one another by means of printed conductor paths (84-90) on the circuit board (Fig. 4).

2. An adjusting device as claimed in claim 1, characterised in that, in order to protect the adjusting device against overload by an internal short circuit current which does not flow through the output terminals (41, 42) of the adjusting device due to a defect in a diode (current path in the reverse direction), the corresponding printed conductor paths (84, 89, 90) of the flexible circuit board (8) are constructed to have a serpentine shape with a determined conductor cross-section to act as safety fuses (S1; S2; S3) (Fig. 5).

## Revendications

1. Dispositif de réglage pour des appareils d'alimentation par le secteur, plus particulièrement pour des trains-jouets et trains-miniatures électriques, du type comportant une plaque de support (6) susceptible de tourner autour d'un axe (1) et servant à recevoir des composants électroniques, plus particulièrement des diodes (31-34; 36, 37) qui sont susceptibles d'être reliées, par l'intermédiaire de conducteurs électriques soudés, avec des contacts glissants (A - G) au moins guidés axialement dans la plaque de support et pressés contre des pistes conductrices imprimées (84-90) prévues sur une première plaque de commutation fixe (7) disposée axialement sur la plaque de support, caractérisé par le fait qu'au-dessus de la plaque de support (6) est montée sur celle-ci une seconde plaque de commutation flexible (8) comportant des pistes conductrices imprimées (84, 90) et que les contacts glissants (A - G) guidés axialement dans la plaque de support (6) et les diodes (31-34; 36, 37) sont fixés mécaniquement et directement à cette plaque de commutation flexible (8), et sont reliés électriquement entre eux par les pistes conductrices imprimées de cette dernière.

2. Dispositif de réglage selon la revendication 1, caractérisé par le fait que pour la protection du dispositif de réglage contre une surcharge due à un courant de court-circuit intérieur ne passant pas par les bornes de sortie (41, 42) du dispositif de réglage et ayant pour origine une défaillance d'une diode (piste de courant dans le sens du blocage), les pistes conductrices imprimées correspondantes (84, 89, 90) de la plaque de commutation flexible (8) sont réalisées, pour servir de fusibles (S1; S2; S3), sous la forme de méandres de section transversale conductrice déterminée.

FIG 1

FIG 2

FIG 3

FIG 4

FIG 5